# EUROPÄISCHE PATENTANMELDUNG

(11) **EP 2 574 935 A2**
(43) Veröffentlichungstag der Anmeldung: **03.04.2013**
(21) Anmeldenummer: 12181130.1
(22) Anmeldetag: 21.08.2012
(51) Int. Cl.: G01R 1/20

(54) **Messwiderstand und Verfahren zur Messung des elektrischen Stromes**

(30) Priorität: 30.09.2011 DE 102011083826
(71) Anmelder: Siemens Aktiengesellschaft, 80333 München (DE)
(72) Erfinder: Hußmann, Jörg, 92318 Neumarkt (DE); Nörl, Gerald, 93133 Burglengenfeld (DE); Schmid, Adolf, 93164 Laaber (DE)

(57) **Zusammenfassung**

Die Erfindung betrifft einen Messwiderstand für einen elektrischen Stromkreis, der die Bauform einer elektrischen Sicherung bzw. eines Trennmessers aufweist.

## Beschreibung

Es ist bekannt den elektrischen Strom in einem elektrischen Stromkreis zu messen. Hierzu sind verschiedene Anordnungen und Verfahren bekannt. Eine Möglichkeit besteht in der Verwendung eines Widerstandes bzw. Messwiderstandes, auch als Shunt bezeichnet. Der Messwiderstand weist einen möglichst konstanten, bekannten Widerstandsbetrag auf. Der Messwiderstand wird in den elektrischen Stromkreis eingebracht. Über den Messwiderstand fällt nach dem Ohmschen Gesetz eine dem elektrischen Strom proportionale elektrische Spannung ab. Diese wird mit einem Spannungsmesser, auch Voltmeter genannt, gemessen. Aus der gemessenen Spannung kann mittels des bekannten Widerstandsbetrages gemäß dem Ohmschen Gesetz der elektrische Strom berechnet werden.

Soll in einer elektrischen Anlage der elektrische Strom gemessen werden, ist ein entsprechender Messwiderstand in den zu messenden Stromkreis einzubringen. Dieser Messwiderstand sollte bereits beim Aufbau der elektrischen Anlage berücksichtigt werden, da in bereits installierten elektrischen Anlagen der Stromfluss und die Leitungen unterbrochen werden müssen, um den Messwiderstand einzubringen, was ein sehr häufig umfangreiches und aufwändiges Vorgehen erfordert. Ferner ist häufig kein Platz mehr für einen Messwiderstand vorhanden bzw. sind Leitungen fest verlegt. Des Weiteren muss ein separates Gehäuse, ein separater Platz, zusätzliche Luft und Kriechstrecken vorgesehen bzw. eingehalten werden. Weiterhin ist für die Nachrüstung Fachpersonal erforderlich, um die Zulassung der Anlage nicht zu gefährden.

Aufgabe der Erfindung ist es, eine Möglichkeit zur Messung des elektrischen Stromes in einer bereits installierten elektrischen Anlage aufzuzeigen.

Diese Aufgabe wird durch einen Messwiderstand nach Anspruch 1, ein Trennmesser nach Anspruch 4, eine Sicherung nach Anspruch 7 oder ein Verfahren nach Anspruch 12 oder 13 gelöst.

Erfindungsgemäß ist vorgesehen einen Messwiderstand an Stelle einer Sicherung bzw. eines Trennmessers in einen Sicherungshalter bzw. einem für das Trennmesser vorgesehenen Halter einzusetzen. Der erfindungsgemäße Messwiderstand weist hierbei die Bauform einer Sicherung bzw. eines Trennmessers auf. Ein weiterer Aspekt der Erfindung besteht darin, eine Sicherung und einen Messwiderstand gemeinsam in der Bauform einer Sicherung unterzubringen.

Der Vorteil der Erfindung besteht darin, dass in bereits installierten elektrischen Anlagen, in denen eine Nachrüstung eines Messwiderstandes aufwändig ist, eine einfache Möglichkeit zur Strommessung durch Ersatz einer Sicherung bzw. eines Trennmessers durch einen Messwiderstand bzw. einer Kombination aus Sicherung und Messwiderstand ermöglicht wird.
Vorteilhafte Ausgestaltungen der Erfindung sind in den abhängigen Ansprüchen angegeben.

In einer vorteilhaften Ausgestaltung der Erfindung weist der Messwiderstand die Bauform einer NH-Sicherung auf. Hierbei sind üblicherweise die Anschlüsse des NH-Sicherungshalters für den Anschluss der Leitungen des Spannungsmessers gut zugänglich.

In einer weiteren vorteilhaften Ausgestaltung der Erfindung weist der Messwiderstand zumindest einen Anschlusspunkt auf, um hier direkt eine Leitung für den Spannungsmesser anzuschließen, damit der Spannungsabfall gemessen werden kann. Die zweite Leitung des Spannungsmessers ist hierbei an einem weiteren Anschlusspunkt des Messwiderstandes bzw. am Sicherungshalter bzw. Halter für das Trennmesser angeschlossen, so dass der Spannungsabfall über dem Messwiderstand gemessen werden kann.

Insbesondere wenn die Sicherung einen in Serie geschalteten Messwiderstand aufweist und der Verbindungspunkt zwischen Sicherung und Messwiderstand als Anschlusspunkt zugänglich ist, ist hierbei eine direkte Messung des Spannungsabfalles über den Messwiderstand möglich.

In einer vorteilhaften Ausgestaltung der Erfindung ist der Anschlusspunkt über eine Öffnung im Gehäuse zugänglich, somit ist ein direkter Berührungsschutz vor elektrischer Spannung für geschirmte Anlangen realisierbar.

In einer vorteilhaften Ausgestaltung der Erfindung ist der Anschlusspunkt auf der Außenseite des Sicherungsgehäuses zugänglich. Hierbei ist ein direkter Anschluss, beispielsweise mittels einer Klemme oder ähnlichem, einer elektrischen Leitung zum Spannungsmesser möglich.

In einer vorteilhaften Ausgestaltung der Erfindung wird die Messung in einem Gleichstromkreis durchgeführt. Da hier häufig Sicherungshalter aus der Wechselstromtechnik, insbesondere aus dem Dreiphasensystem verwendet werden, kann hier ein Trennmesser zur Überbrückung eines Sicherungshalters vorteilhaft durch einen Messwiderstand ersetzt werden und gegebenenfalls mit einer weiteren Sicherung in Reihe geschaltet werden.

Ein Ausführungsbeispiel der Erfindung wird im Folgenden an Hand der Zeichnung näher erläutert.

Es zeigen
Fig. 1 Prinzipdarstellung eines Messwiderstandes in einem Sicherungsgehäuse
Fig. 2 Prinzipdarstellung eines Messwiderstandes mit einer Sicherung in einem Sicherungsgehäuse
Fig. 3 eine weitere Prinzipdarstellung eines Messwiderstandes mit einer Sicherung in einem Sicherungsgehäuse
Fig. 4 eine weitere Prinzipdarstellung eines Messwiderstandes mit einer Sicherung in einem Sicherungsgehäuse
Fig. 5 eine Darstellung eines Messwiderstandes in der Bauform eines Trennmessers

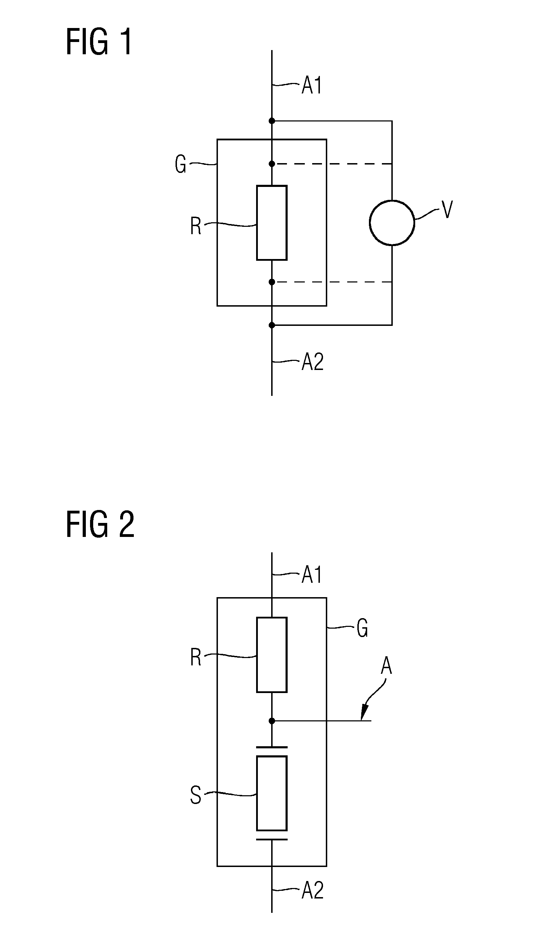

Figur 1 zeigt einen Messwiderstand R in einem Gehäuse G mit einem ersten und einem zweiten Anschluss A1 und A2. An dem ersten und zweiten Anschluss A1 und A2 ist ein Spannungsmesser V angeschaltet. Nach dem Ohmschen Gesetz kann aus dem Quotient aus Spannung und Widerstand der elektrische Strom durch den Messwiderstand berechnet werden.

Figur 2 zeigt einen Messwiderstand gemäß Figur 1, mit dem Unterschied, dass eine Sicherung S in Reihe mit dem Messwiderstand R geschaltet ist. Der Verbindungspunkt zwischen Messwiderstand und Sicherung ist als Anschlusspunkt A nach außen geführt. Der erste Anschluss A1 ist mit dem anderen Anschluss des Messwiderstandes R und der zweite Anschluss A2 ist mit dem anderen Anschluss der Sicherung S verbunden.

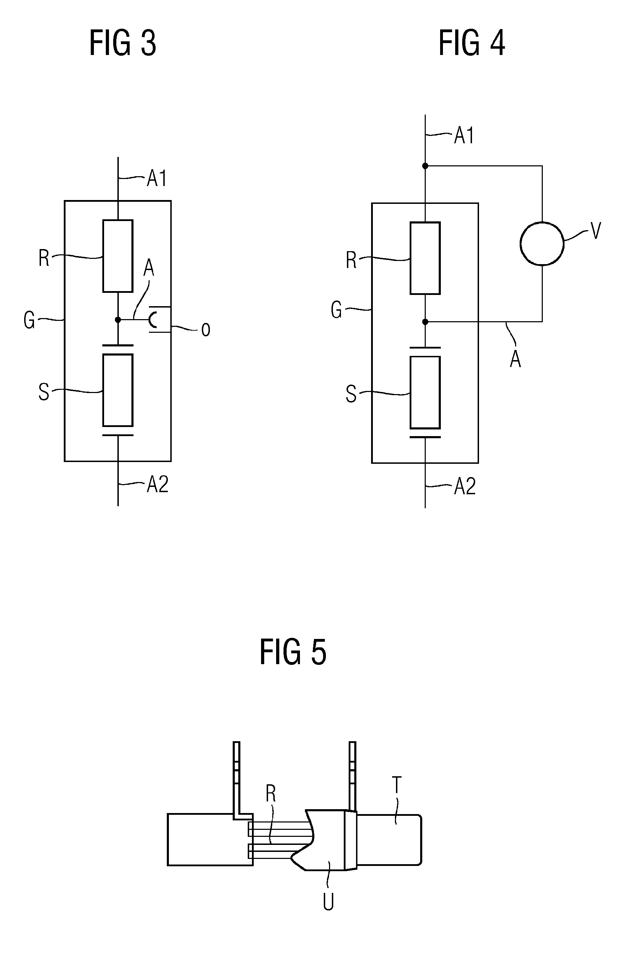

Figur 3 zeigt einen Messwiderstand gemäß Figur 2, mit dem Unterschied, dass der Anschlusspunkt A nicht aus dem Gehäuse G herausgeführt ist, sondern über einen Öffnung O zugänglich ist.

Figur 4 zeigt einen Messwiderstand gemäß Figur 2, mit dem Unterschied, dass ein Voltmeter V analog zu Figur 1 parallel zum Messwiderstand R angeschaltet ist.

Figur 5 zeigt einen Messwiderstand in der Bauform eines Trennmessers T, mit einer möglichen Ummantelung U.

Aspekte der Erfindung werden im Folgenden nochmals dargestellt.
Lastschalter, Trennschalter sowie Lasttrennschalter als Schalter-Sicherungseinheiten oder Sicherungsunterteile werden bestimmungsgemäß in technischen Anlagen verbaut. Damit in oder von einzelnen Abzweigen der fließende Strom gemessen und mitgeschrieben werden kann, werden Messwiderstände bzw. Shunts eingesetzt. Messwiderstände werden abgangsseitig extern verdrahtet, um ein Messen bzw. Aufzeichnen des Spannungsabfalls zu ermöglichen.

In Gleichstromkreisen sowie ein- oder zweipoligen Wechselstromkreisen, in denen Lastschalter, Trennschalter sowie Lasttrennschalter als Schalter-Sicherungseinheiten oder Sicherungsunterteile eingesetzt werden, wird in der Regel in einer Sicherungstasche oder einem Sicherungseinsetzbereich bzw. in einer ersten Sicherungshaltung eine Sicherung bzw. ein Sicherungseinsatz und in einer zweiten Sicherungshaltung des gleichen Stromkreises ein Trennmesser (zur Überbrückung) platziert (IEC 60269-2).

Erfindungsgemäß wird anstelle des Trennmessers ein Messwiderstand bzw. Shunt in der Bauform einer Sicherung bzw. eines Trennmessers eingesetzt.

Ein kundenseitiger Einsatz in der Projektierungsphase sowie der nachträglicher Einsatz eines Messwiderstandes ist möglich. Die abzugreifende Spannung bzw. Signal des Messwiderstandes wird zur Strommessung oder Stromaufzeichnung verwendet.

Lastschalter, Trennschalter sowie Lasttrennschalter als Schalter-Sicherungseinheiten oder Sicherungsunterteile müssen z.B. für NH-Trennmesser-Bauformen (oder anderen Sicherungsbauformen) ausgelegt sein. Ein Messwiderstand in der Bauform einer Sicherung bzw. eines Trennmessers kann universell in allen Lastschaltern, Trennschaltern sowie Lasttrennschaltern eingesetzt werden. Der Messwiderstand soll die maximale Bauform sowie die elektrischen und thermische Anforderungen von Sicherungen einhalten.

Der kundenseitige Einsatz von Messwiderständen in der Projektierungsphase sowie ein Nachrüsten an bestehenden Anlagen wird vereinfacht bzw. ermöglicht. Messwiderstände können mit einer Ummantelung versehen werden, um die Stabilität zu erhöhen. Ein Messwiderstand in der Bauform einer Sicherung kann wie eine normale Sicherung eingesetzt, ausgetauscht oder nachgerüstet werden. Eine Demontage bzw. Abschrauben oder Abnehmen verbauter Geräte oder Leitungen / Kabel ist nicht erforderlich.

## Patentansprüche

1. Messwiderstand für einen elektrischen Stromkreis,
**dadurch gekennzeichnet,**
**dass** der Messwiderstand die Bauform einer elektrischen Sicherung aufweist.

2. Messwiderstand für einen elektrischen Stromkreis nach Anspruch 1,
**dadurch gekennzeichnet,**
**dass** der Messwiderstand die Bauform einer NH-Sicherung aufweist.

3. Messwiderstand für einen elektrischen Stromkreis nach Anspruch 1,
**dadurch gekennzeichnet,**
**dass** der Messwiderstand die Bauform einer standardisierten Sicherung aufweist.

4. Messwiderstand für einen elektrischen Stromkreis,
**dadurch gekennzeichnet,**
**dass** der Messwiderstand die Bauform eines Trennmessers aufweist.

5. Messwiderstand für einen elektrischen Stromkreis nach einem der vorhergehenden Ansprüche,
**dadurch gekennzeichnet,**
**dass** der Messwiderstand einen konstanten Widerstandswert aufweist.

6. Messwiderstand für einen elektrischen Stromkreis nach einem der vorhergehenden Ansprüche,
**dadurch gekennzeichnet,**
**dass** über den Messwiderstand eine dem elektrischen Strom proportionale elektrische Spannung abfällt, die über elektrische Leitungen abgreifbar ist.

7. Sicherung für einen elektrischen Stromkreis,
**dadurch gekennzeichnet,**
**dass** die Sicherung einen Messwiderstand aufweist, der zumindest teilweise im Gehäuse der Sicherung angeordnet ist.

8. Sicherung für einen elektrischen Stromkreis nach Anspruch 7,
**dadurch gekennzeichnet,**
**dass** die Sicherung und der Messwiderstand in Serie geschaltet sind.

9. Sicherung für einen elektrischen Stromkreis nach Anspruch 8,
**dadurch gekennzeichnet,**
**dass** die Sicherung einen Anschlusspunkt umfasst, der mit dem Verbindungspunkt zwischen Sicherung und Messwiderstand verbunden ist.

10. Sicherung für einen elektrischen Stromkreis nach Anspruch 9,
**dadurch gekennzeichnet,**
**dass** der Anschlusspunkt über eine Öffnung im Sicherungsgehäuse zugänglich ist.

11. Sicherung für einen elektrischen Stromkreis nach Anspruch 9,
**dadurch gekennzeichnet,**
**dass** der Anschlusspunkt auf der Außenseite des Sicherungsgehäuses zugänglich ist.

12. Verfahren zur Messung des elektrischen Stromes in einem Stromkreis,
**dadurch gekennzeichnet,**
**dass** an Stelle einer Sicherung für den elektrischen Stromkreis ein Messwiderstand in der Bauform der Sicherung in einen Sicherungshalter eingesetzt wird, über den eine elektrische Spannung gemessen wird, aus der der elektrische Strom ermittelt wird.

13. Verfahren zur Messung des elektrischen Stromes in einem Stromkreis,
**dadurch gekennzeichnet,**
**dass** an Stelle eines Trennmessers ein Messwiderstand in der Bauform eines Trennmessers in den für das Trennmesser vorgesehenen Halter eingesetzt wird, über den eine elektrische Spannung gemessen wird, aus der der elektrische Strom ermittelt wird.

14. Verfahren zur Messung des elektrischen Stromes in einem Stromkreis nach Anspruch 12 oder 13,
**dadurch gekennzeichnet,**
**dass** ein elektrischer Gleichstrom gemessen wird.

15. Verfahren zur Messung des elektrischen Stromes in einem Stromkreis nach Anspruch 12, 13 oder 14,
**dadurch gekennzeichnet,**
**dass** der Stromkreis einen Lastschalter, Trennschalter, Lasttrennschalter oder ein Sicherungsunterteil aufweist.

16. Verfahren zur Messung des elektrischen Stromes in einem Stromkreis nach Anspruch 12, 13, 14 oder 15,
**dadurch gekennzeichnet,**
**dass** an Stelle des Messwiderstandes eine Sicherung mit zugehörigen Messwiderstand eingesetzt wird, die eine Serienschaltung aufweisen und bei dem der Verbindungspunkt zwischen Sicherung und Messwiderstand als Anschlusspunkt zugänglich ist, so dass über dem Messwiderstand eine elektrische Spannung gemessen werden kann.
